# EUROPEAN PATENT APPLICATION

(11) **EP 0 880 157 A2**
(43) Date of publication of application: **25.11.1998**
(21) Application number: 98302971.1
(22) Date of filing: 15.04.1998
(51) Int. Cl.: H01H 13/04

(54) **Electrical part and mounting structure therefor**

(30) Priority: 19.05.1997 JP 128737/97
(71) Applicant: ALPS ELECTRIC CO., LTD., Ota-ku Tokyo 145 (JP)
(72) Inventor: Takahashi, Kazunari, Furukawa-shi, Miyagi-ken (JP)
(74) Representative: Kensett, John Hinton

(57) **Abstract**

In an electrical part, projecting sections (llf) for defining an open section are formed on a bottom face (11a) of a casing (11), so that a height difference is formed between the bottom face of the casing and the projecting sections. Even if the casing is warped and deformed due to air heated to a high temperature during reflow-soldering for surface-mounting the electrical part on a printed circuit board, the deformation of the casing can be absorbed by the height difference, which achieves high-quality soldering.

## Description

The present invention relates to a surface-mount electrical part, and more particularly, to a structure of an electrical part that can be normally reflow-soldered onto a printed circuit board even when a casing thereof is warped and deformed owing to a high temperature during reflow-soldering.

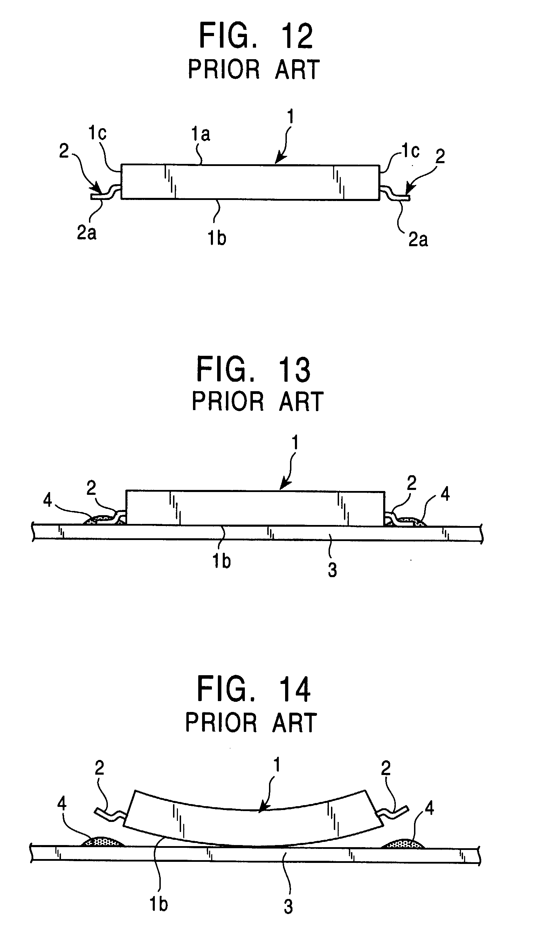

A conventional surface-mount electrical part will be described with reference to Figs. 12 to 14. As shown in Fig. 12, the conventional surface-mount electrical part is provided with a casing 1 having an almost rectangular outward shape and made of heat-resistant resin or the like. Inside the inner space of the casing 1 sandwiched between a top face la and a flat bottom face 1b, circuits (not shown) and the like are placed. A pair of terminals 2 and 2 bent into the shape of an L project from right and left side faces 1c and 1c, and each have a flat substrate mounting face 2a that is formed in almost the same plane as the bottom face 1b of the casing 1.

A method of surface-mounting the conventional electrical part having the above-mentioned structure onto a printed circuit board by soldering with a reflow-soldering apparatus (not shown) will be described with reference to Fig. 13.

First, a predetermined amount of solder paste 4 is applied onto a circuit pattern (not shown) on a printed circuit board 3. The flat bottom face 1b of the electrical part is laid on the surface of the printed circuit board 3 in close contact therewith, and the terminals 2 are positioned on the circuit pattern with the solder paste 4 applied thereon.

Then, the printed circuit board 3 on which the electrical part is placed is conveyed into a high-temperature reflow furnace in the reflow-soldering apparatus.

In this reflow furnace, air heated to a high temperature of about 240°C to 260°C is jetted from below the printed circuit board 3. The heated air heats the printed circuit board 3 and also increases the atmospheric temperature in the reflow furnace to a high temperature to melt the solder paste 4, whereby the electrical part is surface-mounted on the printed circuit board 3 by soldering.

When the above-mentioned conventional electrical part is reflow-soldered, however, since high-temperature heated air is directly blown against the printed circuit board 3 from below, the bottom face 1b of the casing 1 is heated through the printed circuit board 3 and its temperature reaches a high temperature earlier than that of the top face la. That is, a temperature difference is caused between the top face la and the bottom face 1b of the casing 1.

Even if the casing 1 is made of highly heat-resistant resin, thermal expansion of the bottom face 1b is larger than that of the top face la because of this temperature difference, and the casing 1 is thereby curved so that the outer side faces 1c are warped upward, as shown in Fig. 14.

When the casing 1 is thus deformed, the terminals 2 separate from the solder paste 4 applied on the printed circuit board 3, which hinders normal soldering of the electrical part onto the printed circuit board 3.

The present invention has been made to solve the above problem and has as an object the provision of an electrical part that can be normally soldered onto a printed circuit board even when its housing is warped due to a high temperature during reflow-soldering, and a mounting structure for the electrical part.

In order to achieve the above object, according to an aspect of the present invention, there is provided an electrical part including a casing having a bottom face and a side face formed on the periphery, an open section formed on the bottom face so that it penetrates in the direction of the side face at least at the center of the bottom face and is opened downward, and a terminal placed in parallel with the bottom face and having a substrate mounting face, wherein there is formed a height difference between the substrate mounting face of the terminal and the bottom face. According to this structure of the electrical part of the present invention, even if the side face of the casing is warped and the casing is deformed by air heated to a high temperature in a reflow furnace in reflow-soldering the electrical part, the deformation can be absorbed by the height difference between the substrate mounting face of the terminal and the bottom face. As a result, the terminal and the printed circuit board are not separated from each other by much.

Accordingly, it is possible to reliably reflow-solder the electrical part on the printed circuit board, and to achieve surface-mounting of high quality without causing any soldering defects.

A projecting section may be formed at the corner of the bottom face so that its surface is located in almost the same plane as the substrate mounting face of the terminal. In this case, the projecting section can also be formed integrally with the casing by molding, which provides a low-cost electrical part having high workability.

The terminal may be led out from the side face of the casing and bent at the leading end into about the form of an L so that there is formed a height difference between the substrate mounting face of the terminal and the bottom face. Since a large contact area can be obtained between the L-shaped terminal and the printed circuit board, it is possible to reliably and stably surface-mount the electrical part on the printed circuit board.

The terminal may be exposed from the surface of the projecting section and bent at the leading end upward along the side face of the casing in the form of a J so that the surface of the projecting section and the substrate mounting face of the terminal are located in almost the same plane. Since the terminal does not project outward from the casing in this case, the electrical part can be soldered onto the printed circuit board within the width of the casing, and the space factor of the printed circuit board can be increased.

In addition, since the terminal is bent upward along the side face of the casing into the form of a J, the substrate mounting face thereof is exposed from the side face of the casing, which can increase the strength of soldering onto the printed circuit board.

The bottom face may be formed flat and entirely opened, and the terminal may be led out from the side face of the casing and bent at the leading end into about the form of an L. In this case, a height difference can be provided between the substrate mounting face of the terminal and the bottom face without forming any projecting section on the bottom face. Since a space is formed between the entire bottom face of the electrical part and the printed circuit board, it is possible to prevent heat from the high-temperature printed circuit board from being directly applied to the casing of the electrical part during reflow-soldering, and to prevent the performance of the electrical part from being lowered due to heat.

According to another aspect of the present invention, there is a mounting structure for an electrical part, including a casing having a bottom face and a side face formed on the periphery, an open section formed on the bottom face so that it penetrates in the direction of the side face at least at the center of the bottom face and is opened downward, a terminal placed in parallel with the bottom face and having a substrate mounting face, and a printed circuit board for mounting the terminal thereon, wherein the terminal is laid on the printed circuit board, and a space is formed by the open section between the printed circuit board and the bottom face. According to this mounting structure, even if the casing is deformed due to heat during reflow-soldering, the deformation can be absorbed by the space.

Preferably, a projecting section is formed at the corner of the bottom face so that its surface is located in almost the same plane as the substrate mounting face of the terminal, and the surface of the projecting section is mounted on the printed circuit board. Since a space including the open section is formed between the surface of the printed circuit board and the bottom face of the casing, the warp of the casing during reflow-soldering can be absorbed by this space, and the electrical part is thereby allowed to be reliably mounted on the printed circuit board by soldering.

Preferably, the bottom face is formed flat and entirely opened, the terminal is led out from the side face of the casing and bent at the leading end into about the form of an L, and the substrate mounting face of the terminal is mounted on the printed circuit board. In this case, when the electrical part is placed on the printed circuit board, its entire bottom face is not in contact with the printed circuit board, and therefore, heat from the printed circuit board heated to a high temperature is not directly applied to the casing during reflow-soldering. This prevents the performance of the electrical part from being lowered due to heat.

Other objects, features and advantages of the invention will be apparent from the following detailed description taken in connection with the accompanying drawings.

### BRIEF DESCRIPTION OF THE DRAWINGS

Fig. 1 is an exploded perspective view of an electrical part according to a first embodiment of the present invention.

Fig. 2 is a plan view of the electrical part.

Fig. 3 is a cross-sectional view of the electrical part, taken along line III-III of Fig. 2.

Fig. 4 is a cross-sectional view showing the principal part of the electrical part that is mounted on a printed circuit board.

Fig. 5 is a schematic view showing a state in which the electrical part is reflow-soldered.

Fig. 6 is a bottom view showing the shape of projecting sections in the electrical part.

Fig. 7 is a bottom view showing another shape of the projecting sections in the electrical part.

Fig. 8 is a bottom view showing a further shape of the projecting sections in the electrical part.

Fig. 9 is a cross-sectional view showing the principal part of an electrical part according to a second embodiment of the present invention.

Fig. 10 is a cross-sectional view showing the principal part of a modification of the electrical part according to the second embodiment of the present invention.

Fig. 11 is a cross-sectional view showing the principal part of an electrical part according to a third embodiment of the present invention.

Fig. 12 is a schematic view of a conventional electrical part.

Fig. 13 is a schematic view of the conventional electrical part mounted on a printed circuit board.

Fig. 14 is a schematic view showing a state in which the conventional electrical part is reflow-soldered.

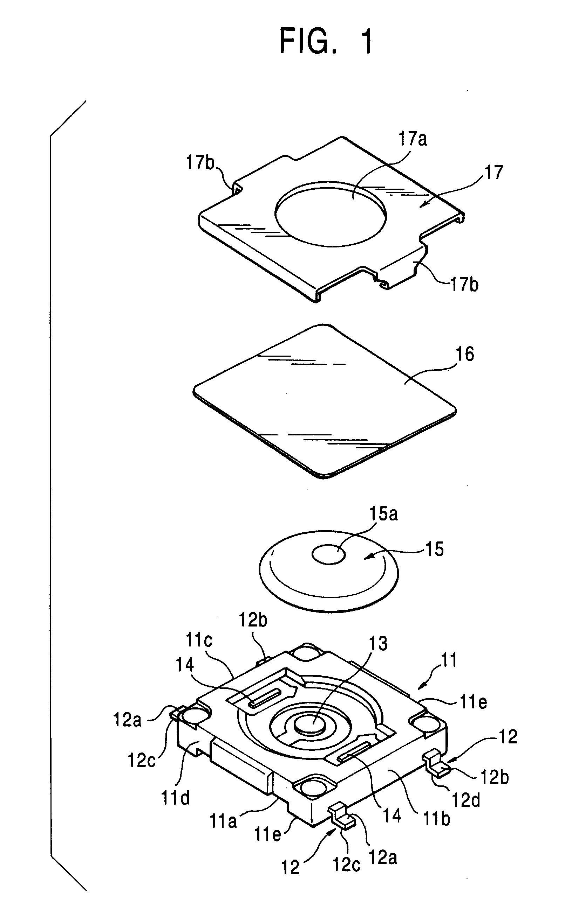

Electrical parts according to some embodiments of the present invention will be described below with reference to pushbutton switches shown in Figs. 1 to 11.

Fig. 1 is an exploded perspective view of a pushbutton switch as an electrical part according to a first embodiment of the present invention. The electrical part includes a casing 11 made of resin and having an almost rectangular outward shape, and the casing 11 is composed of a bottom face 11a at the back center, and opposing side faces 11b and 11c and opposing side faces 11d and 11e on the periphery.

Projecting sections 11f project downward from the corners of the bottom face 11a, and define an open section 11g that penetrates between the side faces 11d and 11e at least at the center of the bottom face 11a and that is opened downward. The projecting sections 11f are formed in a pair on the right and left sides of the bottom face 11a so that the open section 11g is located therebetween.

A pair of terminals 12, each placed in parallel with the bottom face 11a and having substrate mounting faces 12c, are led out from the aforesaid two opposing side faces 11b and 11c of the casing 11.

The pair of terminals 12 include a terminal 12a led out from the two side faces 11b and 11c on one side of the casing 11, and a terminal 12b led out therefrom on the other side.

One of the terminals 12a is connected to a fixed contact 13 that is placed in the center of the inside of the casing 11, and the other terminal 12b is connected to two fixed contacts 14 and 14 that are positioned offset outward from the fixed contact 13. The terminals 12 are formed integrally with the casing 1 by insert-molding.

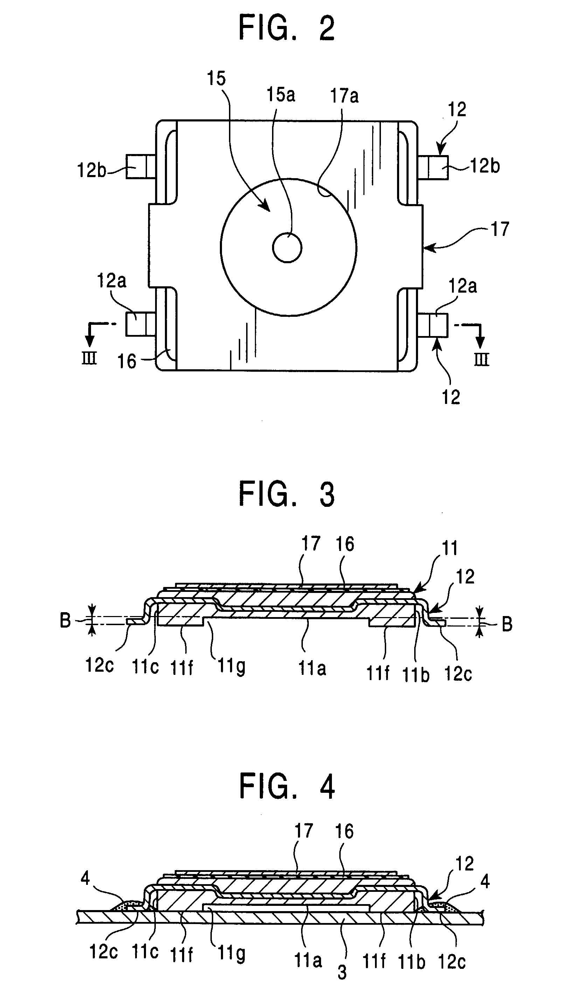

Fig. 2 is a plan view of the electrical part according to the present invention, and Fig. 3 is a cross-sectional view taken along line III-III of Fig. 2. The pair of terminals 12 are, as shown in Fig. 3, each formed by bending its leading ends, which are led out from the side faces 11b and 11c of the casing 11 and bent downward, into about the form of an L in almost the same plane as the surfaces of the projecting sections 11f projecting from the corners of the bottom face 11a, in the same direction as the direction in which the leading ends are led out from the side faces 11b and 11c.

Furthermore, as shown in Fig. 3, there is a height difference B between the bottom face 11a of the casing 11 and the surfaces of the projecting sections 11f. Since the surfaces of the projecting sections 11f and the substrate mounting faces 12c of the terminals 12 are formed in almost the same plane, the height difference B is also provided between the bottom face 11a and the substrate mounting faces 12c.

Above the fixed contacts 13 and 14, there is placed a movable contact 15 formed of a dome-shaped metal leaf spring and provided with a movable section 15a at the center that is vertically movable.

The movable contact 15 is in contact with the two fixed contacts 14 at the lower rim thereof, thereby making electrical connection thereto.

A dust-protective sheet 16 is placed on the movable contact 15 so that it is interposed between the movable contact 15 and a cover frame 17, which will be described later, for insulation therebetween and protection against dust.

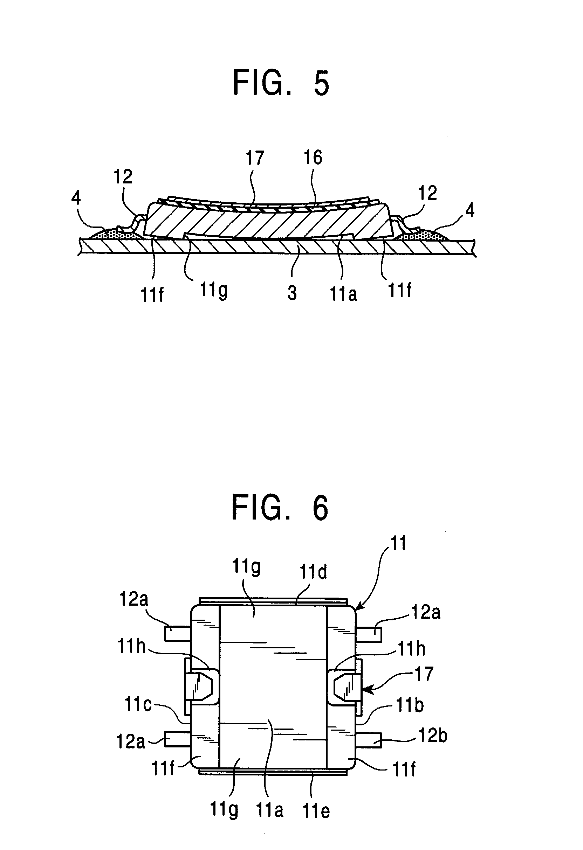

The cover frame 17 is made of metal, and provided with a center hole 17a at the center, and mounting feet 17b on the right and left sides. The mounting feet 17b are set in contact with the side faces 11b and 11c, and the leading ends thereof are, as shown in Fig. 6, fitted by caulking in recessed sections 11h formed on the surfaces of the projecting sections 11f of the casing 11, thereby forming the pushbutton switch as the electrical part of the present invention.

According to the above-mentioned structure of the pushbutton switch, the center section 15a of the movable contact 15 is brought into contact with the fixed contact 13 by pressing the center section 15a with a finger or the like through the center hole 17a of the cover frame 17, whereby the fixed contact 13 and the two fixed contacts 14 are electrically connected.

In order to surface-mount the above pushbutton switch as the electrical part of the present invention onto a printed circuit board 3, a predetermined amount of solder paste 4 is first applied onto a circuit pattern (not shown) on the printed circuit board 3, as shown in a principal cross-sectional view of Fig. 4. The surfaces of the projecting sections 11f projecting from the corners of the bottom face 11a of the casing 11, which define the open section llg penetrating between the side faces 11d and 11e at least at the center of the bottom face 11a and opened downward, are put on the printed circuit board 3 in close contact. Then, the pair of terminals 12 are positioned on the circuit pattern on which the solder paste 4 is applied.

Next, the printed circuit board 3 with the electrical part thereon is conveyed into a high-temperature reflow furnace by a conveyor means of a reflow-soldering apparatus (not shown).

In the reflow furnace, air heated to a high temperature of about 240°C to 260°C is jetted from below the conveyed printed circuit board 3. The heated air heats the printed circuit board 3, and simultaneously elevates the atmospheric temperature in the reflow furnace to a high temperature to melt the solder paste 4, whereby the electrical part of the present invention is surface-mounted on the printed circuit board 3 by soldering.

At this time, since the air heated to a high temperature is directly blown against the printed circuit board 3 from below in the reflow furnace, the bottom face 11a of the casing 11 including the projecting sections 11f is heated through the printed circuit board 3 to a higher temperature than the cover frame 17 on the upper side of the casing 11.

Therefore, even if highly heat-resistant resin is used as the material of the casing 11 of the electrical part, the volume expansion of the bottom face 11a including the projecting sections 11f, which results from thermal expansion during reflow-soldering, is larger than that of the cover frame 17, and the casing 11 is thereby curved and deformed to a degree that the center of the open section 11g on the bottom face 11a makes contact with the surface of the printed circuit board 3, as shown in Fig. 5.

In the electrical part of the present invention, however, since the projecting sections 11f are formed at the corners of the bottom face 11a so that it define the open section 11g at about the center of the bottom face 11a, and there is the height difference B between the surfaces of the projecting sections 11f and the bottom face 11a, such deformation of the casing 11 is absorbed by this height difference B. Thereby, the substrate mounting faces 12c of the pair of terminals 12, which are located on the right and left side faces 11b an 11c and bent into about the form of an L, are prevented from moving much apart from the surface of the printed circuit board 3, as distinct from the above-mentioned conventional electrical part.

Accordingly, even when the casing 11 is deformed by air heated to a high temperature at the aforesaid reflow-soldering, as shown in Fig. 5, the deformation can be absorbed by the height difference B formed by the projecting sections 11f on the bottom face 11a of the casing 11.

Furthermore, since the height difference B can absorb the deformation of the casing 11, the mounting faces 12c of the terminals 12 do not move much apart from the solder paste 4 on the printed circuit board 3. As a result, it is possible to reliably reflow-solder the electrical part of the present invention on the printed circuit board 3 without causing any soldering defects.

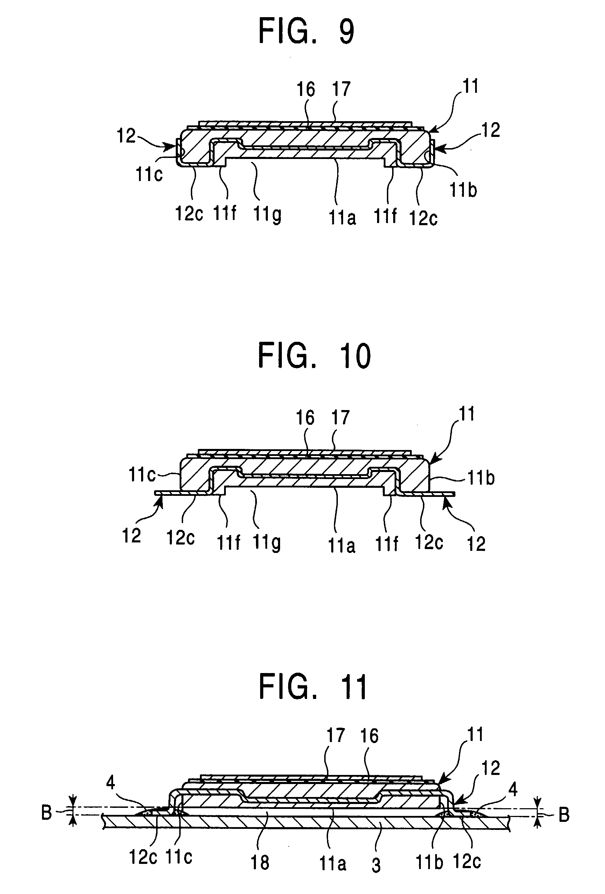

Fig. 9 shows an electrical part according to a second embodiment of the present invention. In this electrical part, the pair of terminals 12 are bent downward inside the casing 11, and led out from the side faces 11b and 11c in the direction parallel to the bottom face lla of the casing 11 in almost the same plane as the surfaces of the projecting sections llf formed at the corners of the bottom face 11a. The leading ends of the led-out terminals 12 are bent upward along the side faces 11b and llc in the form of a J.

Fig. 10 shows a modification of the electrical part according to the second embodiment of the present invention. In this modification, the pair of terminals 12 are also bent downward inside the casing 11, and led out from the side faces 11b and 11c in the direction parallel to the bottom face 11a in almost the same plane as the surfaces of the projecting.sections 11f that are formed at the corners of the bottom face 11a, while the leading ends of the led-out terminals 12 are further extended outward in parallel with the bottom face 11a.

Fig. 11 shows an electrical part according to a third embodiment of the present invention. Referring to Fig. 11, the bottom face 11a of the casing 11 is shaped flat, and a pair of terminals 12 having substrate mounting faces 12c are led out from the side faces 11b and 11c in the direction parallel to the bottom face 11a. The substrate mounting faces 12c of the terminals 12 are projected downward from the flat bottom face 11a, whereby a height difference B is formed between the bottom face 11a of the casing 11 and the substrate mounting surfaces 12c of the terminals 12.

In such an electrical part according to the third embodiment of the present invention, the terminals 12 are projected downward from the bottom face 11a of the casing 11, and bent into about the form of an L at the height difference B.

Accordingly, when the electrical part of the third embodiment is mounted on the printed circuit board 3, a space 18 of predetermined dimensions, which is open on all sides, is formed by the height difference B between the bottom face 11a of the casing 11 and the printed circuit board 3, as shown in Fig. 11, even if the projecting sections 11f as in the aforesaid first and second embodiments are not formed at the corners of the bottom face 11a of the casing 11.

If the casing 11 is warped owing to a high temperature for reflow-soldering, the warp can be absorbed by this space 18 that is open on all sides.

While the pushbutton switch is given as an example in the description of the embodiments of the present invention, the present invention is not limited to the pushbutton switch, and is applicable to any surface-mount electrical part that has terminals led out from the side faces of the casing.

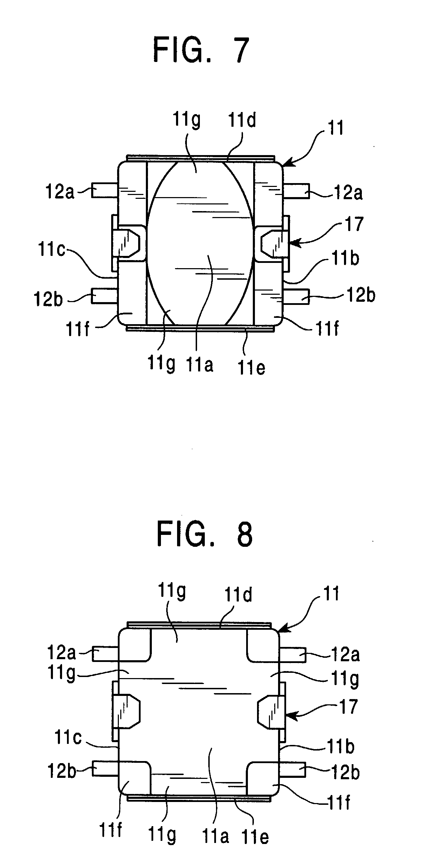

Furthermore, the shapes of the bottom face 11a and the projecting sections 11f of the casing 11 in the electrical part of the present invention are not limited to those shown in the bottom view of Fig. 6. As a variation, the inner surfaces of the projecting sections 11f for defining the open section 11g may be shaped like arcs, as shown in Fig. 7.

Still furthermore, as shown in Fig. 8, the projecting sections 11f may be formed at the four corners of the bottom face 11a so that four open sections 11g are formed.

While the present invention has been described in connection with the particular embodiments, it is to be understood to those skilled in the art that various modifications may be made without departing from the scope of the appended claims.

## Claims

1. An electrical part, comprising:
a casing having a bottom face, and a side face formed on the periphery;
an open section formed on said bottom face so that it penetrates in the direction of said side face at least at the center of said bottom face and is opened downward; and
a terminal placed in parallel with said bottom face and having a substrate mounting face,
wherein a height difference is provided between said substrate mounting face of said terminal and said bottom face.

2. An electrical part according to claim 1, wherein a projecting section is formed at the corner of said bottom face, and the surface of said projecting section and said substrate mounting face of said terminal are formed in almost the same plane.

3. An electrical part according to claim 2, wherein said terminal is led out from said side face of said casing, and the leading end thereof is bent into about the form of an L so that a height difference is provided between said substrate mounting face of said terminal and said bottom face.

4. An electrical part according to claim 1 or 2, wherein said terminal is exposed from the surface of said projecting section, the surface of said projecting section and said substrate mounting face of said terminal are formed in almost the same plane, and the leading end of said terminal is bent upward along said side face of said casing in the form of a J.

5. An electrical part according to claim 1, wherein said bottom face is formed flat and entirely opened, said terminal is led out from said side face of said casing, and the leading end of said terminal is bent into about the form of an L.

6. An electrical part mounting structure, comprising:
a casing having a bottom face, and a side face formed on the periphery;
an open section formed on said bottom face so that it penetrates in the direction of said side face at least at the center of said bottom face and is opened downward;
a terminal placed in parallel with said bottom face and having a substrate mounting face; and
a printed circuit board for mounting said terminal thereon,
wherein said terminal is laid on said printed circuit board, and a space is formed by said open section between said printed circuit board and said bottom face.

7. An electrical part mounting structure according to claim 6, wherein a projecting section is formed at the corner of said bottom face, the surface of said projecting section and said substrate mounting face of said terminal are formed in almost the same plane, and the surface of said projecting section is mounted on said printed circuit board.

8. An electrical part mounting structure according to claim 6, wherein said bottom face is formed flat and entirely opened, said terminal is led out from said side face of said casing, the leading end of said terminal is bent into about the form of an L, and said substrate mounting face of said terminal is mounted on said printed circuit board.
